# FASCICULE DE BREVET EUROPEEN

(11) **EP 0 980 534 B1**
(45) Date de publication et mention de la délivrance du brevet: **14.04.2004**
(21) Numéro de dépôt: 99937995.1
(22) Date de dépôt: 02.03.1999
(51) Int. Cl.: G02B 5/20, C03C 17/36, G02B 5/28

(54) **SUBSTRAT TRANSPARENT MUNI D'UN EMPILEMENT DE COUCHES REFLECHISSANT LE RAYONNEMENT THERMIQUE**
TRANSPARENTES SUBSTRAT MIT EINER FOLGE VON SCHICHTEN ZUR REFLEXION THERMISCHER STRAHLUNG
TRANSPARENT SUBSTRATE PROVIDED WITH A STACK OF LAYERS REFLECTING THERMAL RADIATION

(30) Priorité: 03.03.1998 DE 19808795
(43) Date de publication de la demande: 23.02.2000
(73) Titulaire: SAINT-GOBAIN GLASS FRANCE, 92400 Courbevoie (FR)
(72) Inventeur: LE MASSON, Pascal, F-75012 Paris (FR); HANS, Alfred, D-52159 Roetgen (DE); HUHN, Norbert, D-52134 Herzogenrath (DE); FISCHER, Klaus, D-52477 Alsdorf (DE); MAURER, Marc, B-4800 Verviers (BE)
(74) Mandataire: Cardin, Elise
(86) Numéro de dépôt international: PCT/FR1999/000466
(87) Numéro de publication internationale: WO 1999/045415

(56) Documents cités:
- EP-A- 0 698 585
- EP-A- 0 718 250
- EP-A- 0 747 330
- DE-A- 3 941 027
- DE-A- 4 422 830
- US-A- 4 985 312
- PATENT ABSTRACTS OF JAPAN vol. 013, no. 512 (M-893), 16 novembre 1989 & JP 01 206035 A (NIPPON SHEET GLASS CO LTD), 18 août 1989

## Description

L'invention concerne un empilement de couches réfléchissant au moins en partie dans l'infrarouge et réfléchissant notamment le rayonnement thermique pour substrats transparents, comprenant au moins une couche »fonctionnelle » et des couches « antireflets » qui sont disposées des deux côtés de la couche d'argent.

On comprend au sens de l'invention par « couche(s) fonctionnelle(s) » la ou les couches qui ont, dans l'empilement, les propriétés de réflexion dans l'infrarouge et/ou dans le rayonnement solaire, et qui sont généralement métalliques, plus particulièrement à base de métal noble du type Ag (contenant éventuellement aussi des constituants minoritaires, par exemple une faible teneur en un autre métal). Les couches d'argent sont en effet hautement réfléchissantes dans l'infrarouge et on peut exploiter ainsi leur propriété anti-solaire ou bas-émissive.

On comprend au sens de l'invention par « couches antireflets » une couche ou une superposition de couches ayant notamment une fonction d'ajustement de l'aspect optique de l'empilement, visant à abaisser la réflexion lumineuse de celui-ci et généralement à base de matériaux diélectriques du type composés métalliques tels que des oxydes métalliques.

On a ainsi affaire, dans la présente invention, à des empilements du type (couche antireflet/couche fonctionnelle/couche antireflets), séquence éventuellement répétée n fois, avec n = 1, 2, 3, .... A noter que peuvent être aussi prévues aux interfaces entre les couches antireflets et les couches fonctionnelles de fines couches, généralement en métal, destinées à protéger, et/ou faciliter l'adhésion des couches fonctionnelles. On les désigne parfois sous le terme de « couches sacrificielles » quand elles sont sur la couche fonctionnelle et qu'elles s'oxydent au moins partiellement, suite au dépôt suivant d'une couche à base d'oxyde par pulvérisation cathodique réactive en présence d'oxygène.

L'invention s'intéresse notamment à une variante de ce type d'empilement où la couche antireflet disposée sous la couche fonctionnelle à base d'argent comprend une couche partielle supérieure formée d'oxyde de zinc immédiatement contiguë à la couche d'argent et une couche partielle supplémentaire disposée par dessous.

Un empilement de couches de ce genre est connu du document DE-39 41 027 A1. Dans cet empilement, la couche partielle qui est disposée sous la couche d'oxyde de zinc et qui fait partie de la couche antireflet « inférieure » consiste en un oxyde métallique du groupe formé par l'oxyde d'étain, le dioxyde de titane, l'oxyde d'aluminium, l'oxyde de bismuth ou un mélange de deux ou plusieurs de ces oxydes. L'épaisseur de la couche d'oxyde de zinc ne peut s'élever à plus de 15 nm. Cette couche d'oxyde de zinc améliore considérablement de la stabilité de la couche d'argent contre la corrosion. Il est à présumer que ceci peut être attribué au fait que la couche d'argent croît sur la couche de ZnO de façon particulièrement régulière et exempte de défauts.

Des empilements à plusieurs couches comprenant de l'argent comme couche fonctionnelle et une couche d'oxyde de zinc disposée immédiatement sous la couche d'argent sont également connus des brevets EP-0 464 789 B1 et EP-0 698 585 A1. Dans les empilements de couches connus de ces publications, la couche antireflet inférieure consiste soit totalement en oxyde de zinc, soit en plusieurs couches partielles alternantes de ZnO et SnO₂.

Les couches d'oxyde de zinc, ont comme couches inférieures pour les couches d'argent, une influence très avantageuse sur la couche d'argent et ses propriétés. Elles ont, par ailleurs, l'inconvénient que des contraintes de compression internes notables apparaissent dans les couches de ZnO dans les conditions habituelles de pulvérisation cathodique. Ces contraintes de compression internes dans les couches de ZnO peuvent avoir un effet défavorable sur l'empilement de couches. Comme il est exposé en détail, en particulier, dans le brevet EP-0 464 789 B1, la couche d'oxyde de zinc peut se délaminer de la couche d'argent sous l'effet des contraintes de compression internes.

Les empilements de couches comportant des contraintes internes sont particulièrement défavorables lorsqu'ils sont appliqués sur des films de support mince à base de polymère(s), notamment organique(s), par exemple, sur des films minces de polytéréphtalate d'éthylène (PET). Ces films de PET ont, en règle générale, une épaisseur de l'ordre de 30 à 50 µm. Les films de PET ainsi revêtus sont de plus en plus utilisés par exemple, pour la fabrication de vitrages feuilletés ayant notamment des propriétés de réflexion de la chaleur. On dispose le film de PET en sandwichs entre deux feuilles de verre de type silico-sodo-calcique à l'aide de deux films adhésifs à base de polymère thermoplastique, par exemple, en polyvinylbutyral (PVB). Il est apparu que les films de type PET qui sont revêtus d'empilements de couches qui comprennent une couche de ZnO sous la couche d'argent s'enroulent sur eux-mêmes sous l'influence des contraintes de compression internes dans l'empilement de couches, de sorte que leur manipulation et leur transformation deviennent problématiques.

L'invention a pour but de mettre au point un empilement de couches du genre décrit plus haut, comprenant notamment une couche de ZnO immédiatement sous la couche d'argent et qui, déposés sur des films de polymère de type PET, ne présentent pas les inconvénients mentionnés ci-dessus, c'est-à-dire qui n'ont pas tendance à s'enrouler sur eux-mêmes une fois revêtus des couches. Il s'agit notamment de faire en sorte que les contraintes internes dans l'empilement de couches soient abaissées/réduites au minimum voire complètement supprimées.

Le système de couches préféré conforme à l'invention se définit de la façon suivante : il s'agit d'un empilement de couches réfléchissant le rayonnement thermique pour substrats transparents, comprenant au moins une couche fonctionnelle à base d'argent et des couches antireflets qui sont disposées des deux côtés de la couche d'argent et qui sont formées d'un ou plusieurs composés métalliques, la couche antireflet disposée sous la couche d'argent comprenant une couche partielle supérieure formée d'oxyde de zinc immédiatement contiguë à la couche d'argent et une couche partielle supplémentaire disposée par-dessous. Cet empilement de couches se distingue par le fait que la couche partielle supplémentaire qui est disposée sous la couche d'oxyde de zinc et qui appartient à la couche antireflet inférieure est une couche de nitrure d'aluminium se trouvant sous des contraintes de traction internes.

De préférence, l'empilement est tel que l'ampleur des contraintes de traction internes de la couche de nitrure d'aluminium correspond par ajustement des paramètres de revêtement à peu près à l'ampleur des contraintes de compression internes dans la couche d'oxyde de zinc, de façon que les contraintes de traction et de compression des deux couches partielles contiguës s'égalisent au moins pour la majeure partie.

De préférence, l'empilement est tel que la couche d'oxyde de zinc a une épaisseur de moins de 15 nm et, de préférence, de moins de 12 nm, et avantageusement d'au moins 5 à 8 nm.

Selon un mode de réalisation de l'empilement selon l'invention celui-ci comprend deux couches fonctionnelles à base d'argent qui sont séparées l'une de l'autre par une couche antireflet supplémentaire. Cette couche antireflet supplémentaire comprend aussi deux couches partielles, à savoir une couche immédiatement contiguë à la couche d'argent supérieure et formée d'oxyde de zinc se trouvant sous des contraintes de compression internes et une couche partielle contiguë à la couche d'argent inférieure et formée de nitrure d'aluminium se trouvant sous des contraintes de traction internes.

Un exemple d'empilement selon l'invention se caractérise par la structure suivante (AlN=Nitrure d'Aluminium) :

Substrat/AIN/ZnO/Ag/Ti/TiO₂

Un autre exemple se caractérise par la structure suivante :

Substrat/AlN/ZnO/Ag/AlN

ou par la structure suivante :

Substrat/AlN/ZnO/Ag/AlN/ZnO/Ag/AlN

L'invention a également pour objet l'utilisation d'un tel empilement de couches pour revêtir des films de polymère mince, en particulier de PET, avec notamment la condition que les paramètres de dépôt des couches d'AlN formées par pulvérisation réactive d'une cathode à base d'aluminium métallique soient choisis de façon que le film revêtu ne présente, après la formation du revêtement, pas de courbure sensible induite par des contraintes internes à l'empilement.

L'invention tire avantage du fait que lors de la pulvérisation cathodique de couches d'AlN, il est possible, par le choix des paramètres des conditions de pulvérisation, par exemple par modification du rapport AR :N₂ dans le gaz de travail, de modifier dans de larges limites les contraintes mécaniques internes dans la couche d'AlN. Ainsi, il ressort, par exemple, de la publication « Stress tuning in ALN thin films », Z. Vakuum in der Praxis (1991) n° 2 - pages 142 à 147 que suivant le rapport Ar :N₂, qui a été modifié dans le domaine de 1 :3 jusqu'à 3 :1, tant des contraintes de compression internes relativement élevées que des contraintes de traction internes relativement élevées peuvent être obtenues sans que des différences significatives du rapport Ar :N puissent être constatées dans la couche d'AlN elle-même. Les contraintes internes sont expliquées plutôt uniquement par la microstructure de la couche d'AlN, des contraintes de traction internes étant générées dans la couche quand on choisit des conditions de pulvérisation cathodique conduisant à une faible densité d'empilement des cristaux d'AlN.

Les conditions optimales pour la fabrication de la succession de couches conforme à l'invention peuvent être déterminées empiriquement par des essais dans chaque cas particulier. Par exemple, on peut déposer par pulvérisation cathodique (assistée par champ magnétique de préférence) sur des substrats minces, par exemple de minces films de PET, successivement une couche d'AlN et une couche de ZnO ayant les épaisseurs de couche souhaitées. Suivant le signe de la contrainte interne résultante dans cette succession de couches, le film revêtu va s'incurver et s'enrouler dans un sens ou l'autre. Les conditions de pulvérisation cathodique pour la couche d'AlN sont ensuite modifiées intentionnellement d'après le résultat observé jusqu'à ce que la pellicule de PET ne présente plus de déformations notables après la formation du revêtement. Les conditions de pulvérisation cathodique trouvées de cette façon servent alors de paramètres pour la formation de l'empilement dans les conditions de fabrication.

La structure de couches conforme à l'invention peut être avantageuse et trouver son application pour tous les substrats. Elle est cependant d'un avantage particulier pour le revêtement de films de polymère mince du fait qu'il est possible d'empêcher de cette façon que les films revêtus s'enroulent, de sorte que leur manipulation est facilitée lors de la mise en pratique de l'invention. Les films de PET présentent souvent des contraintes propres thermostabilisées qui sont imposées par le procédé de fabrication. De même, il est possible que lors de l'opération de pulvérisation cathodique, sous l'effet de la température et/ou par une déformation plastique des films, les contraintes internes présentes à l'origine soient modifiées ou de nouvelles contraintes internes soient induites. Il est évident dans ces cas que lors de la détermination des conditions de pulvérisation cathodique optimale pour la couche d'AlN, ces contraintes propres du film doivent aussi être prises en compte de façon que ce ne soit pas l'empilement comme tel qui soit exempt de contraintes internes résultantes, mais le film revêtu dans son ensemble.

Plus généralement, on peut définir également l'invention de la façon suivante : l'invention a également pour objet un substrat transparent, tout particulièrement sous forme d'un film de polymère souple du type PET muni d'un empilement de couches minces comportant au moins une couche fonctionnelle métallique à propriétés de réflexion dans l'infrarouge du type Ag disposée entre deux couches à base de matériau diélectrique antireflets, ce que l'on entend ici par couche « fonctionnelle » et « couche antireflets » ayant été spécifié plus haut. La couche antireflets « inférieure » disposée entre la couche fonctionnelle et le substrat est soit une monocouche à base d'AlN modifié dont le niveau de contraintes est équilibré (relaxé) soit une superposition de couches comprenant au moins une couche d'AlN surmontée d'une couche d'oxyde métallique dont les niveaux de contrainte se compensent/ s'annulent au moins pour partie.

On retrouve ainsi la variante décrite précédemment, à savoir une couche antireflets de type AlN/ZnO où le niveau de contrainte en traction de la couche d'AlN vient compenser largement si ce n'est complètement le niveau de contrainte en compression de la couche en ZnO. On prévoit aussi une autre variante où la couche antireflets ne comprend que de l'AIN et où cette fois cette couche doit être substantiellement dépourvue de contraintes quelles qu'elles soient, pour arriver au même résultat que dans la variante bi-couche. La variante « bi-couche » présente l'avantage de conserver la couche d'oxyde de type ZnO connue pour être favorable à un bon mouillage de la couche d'argent, la variante « monocouche » présentant quant à elle l'avantage d'un empilement plus simple, moins long à fabriquer, avec moins de couches.

La couche à base d'AlN utilisée dans la couche antireflets inférieure peut notamment comprendre un autre métal minoritaire, notamment du zinc, par exemple dans une proportion de 0,1 à 10% atomique par rapport à l'aluminium.

De préférence, la couche d'oxyde de type ZnO de la couche antireflets inférieure est contiguüe à la couche fonctionnelle. On peut aussi prévoir d'intercaler entre elles une fine couche métallique, de type titane, alliage ou nickel comme NiCr, niobium, ... L'empilement peut contenir une seule couche fonctionnelle ou n couches fonctionnelles avec n ≥ 2. Dans cette configuration, il faut prévoir des couches antireflets « intermédiaires » entre les deux couches fonctionnelles quand n = 2 ou entre deux couches fonctionnelles successives quand n > 2.

Cette couche antireflets « intermédiaire » ou au moins l'une d'entre elles peut comporter, à la façon de la couche antireflets « inférieure », une monocouche à base d'AlN modifié de façon à ce que son niveau de contrainte soit équilibré (relaxé) ou une superposition de couches comprenant au moins une couche à base d"AlN surmontée d'une couche d'oxyde métallique du type ZnO dont les niveaux de contraintes se compensent/ s'annulent au moins pour partie.

Avantageusement, la couche fonctionnelle (ou au moins l'une d'entre elles s'il y en a plusieurs) est surmontée d'une fine couche métallique sacrificielle du type Nb, Ti, NiCr, ce qui est notamment important si on dépose au-dessus des couches de diélectrique en oxyde par pulvérisation cathodique en conditions oxydantes.

Avantageusement, les couches antireflets « intermédiaires » et/ou « supérieures » (« supérieures » correspond aux couches qui « terminent » l'empilement) contiennent des couches à base d'oxyde métallique choisi parmi l'un au moins des oxydes suivants : SnO₂, Ta₂O₅, TiO₂, Nb₂O₅, ZrO₂, TiO₂ et/ou des couches à base de nitrure du type AlN ou Si₃N₄.

L'invention s'applique aussi à des revêtements antireflets inférieurs multi-couches où le ZnO est remplacé par un autre oxyde présentant un niveau de contrainte (traction ou compression) donné que l'association avec la couche à base d'AlN va permettre d'équilibrer, de compenser en grande partie (SiO₂, WO₃, ...).

L'invention peut s'appliquer à n'importe quel substrat transparent rigide comme du verre, certains polycarbonates comme le PMMA (polyméthacrylate de métyle) ou plus spécifiquement, à des substrats sous forme de films de polymère souple comme le PET, certains polyesters, .... L'invention permet que le film polymère souple de ce type soit essentiellement dépourvu de rayon de courbure « involontaire » après dépôt des couches.

L'invention concerne également l'utilisation du film revêtu pour fabriquer des vitrages feuilletés fonctionnalisés, anti-solaires ou bas-émissifs, et les vitrages feuilletés ainsi obtenus.

L'invention concerne également le procédé de fabrication du revêtement sur le substrat du type polymère souple, par pulvérisation cathodique, le concept de l'invention étant de moduler les paramètres de dépôt par pulvérisation réactive de la ou des couches constitutive(s) de la couche antireflets inférieure au moins de façon à minimiser, voire à annuler, son niveau de contrainte global de façon à n'induire substantiellement aucune courbure dans le film du fait de contraintes internes. Pour ce faire, deux paramètres, notamment, peuvent être ajustés de façon appropriée, à savoir la pression globale de l'atmosphère dans laquelle s'effectue le(s) dépôt(s), et le ratio entre la quantité de gaz inerte (Ar) et réactif (O₂ ou N₂) dans l'atmosphère réactive.

Des exemples d'empilements de couches selon l'invention déposés sur des films de polymère en PET sont décrits plus en détail ci-après.

### EXEMPLE 1

Un empilement de couche réfléchissant le rayonnement thermique comprenant la succession de couches :

substrat/AlN/ZnO/Ag/Ti/TiO₂

doit être appliqué sur un film de PET d'une épaisseur de 50 µm de la société Hoechst suivant le procédé de la pulvérisation cathodique réactive assistée par champ magnétique.

Pour déterminer les conditions de pulvérisation cathodique optimale pour la couche antireflet inférieure formée des deux couches partielles AlN/ZnO, on revêt d'abord dans une installation de pulvérisation cathodique de laboratoire de la société Leybold des éprouvettes de films de PET de dimensions de 30 x 30 cm successivement de deux couches partielles de 30 nm d'AlN et de 10 nm de ZnO. La pulvérisation est réalisée par le procédé de pulvérisation dans le plan en courant continu. Après la formation du revêtement, on évalue la déformation du film en retenant comme façon d'apprécier quantitativement les contraintes internes du film revêtu la mesure du rayon de courbure que le film prend après la formation du revêtement. La structure de couches est considérée comme bonne lorsque le film revêtu ne s'incurve plus après avoir été retirée de l'installation de revêtement, mais conserve sa forme plane.

Après plusieurs essais, il ressort que les conditions de revêtement optimales sont atteintes lorsque la couche d'AlN est appliquée par pulvérisation réactive d'une cible en aluminium pur dans un mélange de gaz de travail argon-azote ayant un rapport Ar :N₂ de 2,5 : 1, tandis que la couche de ZnO est formée par pulvérisation réactive d'une cible en zinc métallique dans un mélange gazeux d'argon et d'oxygène ayant un rapport Ar :O₂ de 1 : 1. Dans ces conditions, les éprouvettes de films revêtus de cette double couche ne subissent aucune déformation, c'est-à-dire que les contraintes internes dans les diverses couches du film revêtu s'annulent par addition.

Après que les conditions de pulvérisation cathodique ont été déterminées de cette façon pour la couche antireflet inférieure, un système de plusieurs couches ayant la structure de couches suivantes et les épaisseurs de couches ci-après est appliquée dans la même installation de revêtement sur un film de PET d'une épaisseur de 50 µm, les épaisseurs de couches étant indiquées en nm :

substrat-30 AlN-10 Ag-1 Ti-30 TiO₂

La pulvérisation de la cible d'Al a lieu à nouveau dans une atmosphère Ar :N₂ ayant un rapport Ar :N₂ de 2,25 :1 suivant le procédé de pulvérisation cathodique dans le plan en courant continu et la pulvérisation de la cible de Zn a lieu dans une atmosphère Ar :O₂ ayant un rapport Ar :O₂ de 1 :1 également suivant le procédé de pulvérisation cathodique dans le plan en courant continu. Les couches suivantes sont aussi déposées par le procédé de pulvérisation cathodique dans le plan en courant continu, le gaz de travail pour la pulvérisation d'Ag et Ti étant formé d'argon pur, et le gaz de travail pour la pulvérisation réactive de la couche de TiO₂ consistant en un mélange Ar :O₂ ayant un rapport Ar :O₂ de 1,4 :1.

A l'aide du film revêtu, on fabrique un vitrage feuilleté en assemblant à l'aide de deux feuilles de polyvinuylbutyral d'une épaisseur de 0,38 mm la feuille de PET revêtue avec deux feuilles de verre flotté chacune d'une épaisseur de 2,1 mm, à l'aide de la chaleur et d'une mise sous pression, de façon connue. Même après la conversion en un vitrage feuilleté, la feuille de PET revêtue ne présente aucun défaut tel que des déchirures ou déformations superficielles, et le vitrage feuilleté présente au contraire un aspect impeccable.

Les propriétés optiques qui sont déterminées suivant un procédé de mesure classique correspondent aux exigences en matière de transmission lumineuse, de réflexion lumineuse et de neutralité de teinte.

Les tests réalisés pour la détermination de la résistance de la corrosion de l'empilement des couches à savoir le test d'humidité suivant la norme ANSI Z 26.1, test n° 3 de même que le test de brouillard de pulvérisation de sels suivant la norme DIN 50021 donnent également de bons résultats.

### EXEMPLE 2

On dépose un empilement de plusieurs couches présentant la structure de couches suivante sur un film de PET d'une épaisseur de 50 µm, l'épaisseur des diverses couches étant à nouveau indiquée en nm :

substrat-30 AlN-10 ZnO-10 Ag-82 AlN-10 ZnO-10 Ag-40 AlN

Les conditions de pulvérisation pour les diverses couches, en ce qui concerne les gaz de travail et les procédés de pulvérisation cathodique appliqués, correspondent aux conditions indiquées dans l'exemple 1. L'application d'une couche métallique sacrificielle mince sur chacune des deux couches d'argent n'est pas nécessaire du fait que le gaz de travail pour chacune des couches d'AlN suivantes est totalement exempte d'oxygène.

Pour évaluer l'utilité et les propriétés de l'empilement de couches dans un verre feuilleté, le film revêtu est à nouveau assemblé avec deux feuilles de polyvinylbutyral chacune de 0,38 mm et deux feuilles de verre flotté chacune d'une épaisseur de 2,1 mm en appliquant la chaleur et la pression suffisantes. Des tests sont réalisés sur le vitrage feuilleté achevé.

D'après l'aspect optique du vitrage, cet empilement de couches présente une très bonne apparence dans le vitrage feuilleté, c'est-à-dire qu'aucune déchirure ou déformation n'est constatée dans le film revêtu.

Les propriétés optiques du vitrage feuilleté qui sont déterminées suivant un procédé de mesure habituel correspondent en matière de transmission lumineuse et de réflexion lumineuse dans le domaine du spectre visible, de transmission de l'énergie totale et de la neutralité de nuances, aux exigences imposées pour l'utilisation du vitrage feuilleté comme pare-brise d'un véhicule automobile.

Pour l'évaluation de la résistance à la corrosion de l'empilement de couches dans le vitrage feuilleté, on effectue les tests suivants :
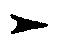 test d'humidité suivant la norme ANSI Z 26,1 (test n° 3) : selon ce test, l'éprouvette est exposée pendant une durée de 14 jours à une température de 40°C à une atmosphère d'une humidité relative de 100%. On ne constate ni trace de corrosion ni délamination.

Selon le test de pulvérisation de sels suivant la norme DIN 50021, les éprouvettes sont exposées pendant 10 jours au nuage de pulvérisation. On constate quelques petites traces de corrosion dans le contour des éprouvettes, mais aucune délamination.

## Revendications

1. Substrat transparent, notamment sous forme d'un film de polymère(s) souple(s), muni d'un empilement de couches minces comportant au moins une couche fonctionnelle métallique à propriétés de réflexion dans l'infrarouge du type Ag disposée entre deux couches à base de matériau diélectrique « antireflets », ***caractérisé en ce que*** la couche antireflets « inférieure » disposée entre la couche fonctionnelle et le substrat est une monocouche à base d'AlN , Nitrure d'Aluminium, modifié dont le niveau de contraintes est équilibré ou est une superposition de couches comprenant au moins une couche d'AlN surmontée d'une couche d'oxyde métallique dont les niveaux de contraintes se compensent/ s'annulent au moins pour partie.

2. Substrat selon la revendication 1, ***caractérisé en ce que*** la couche antireflets « inférieure » comprend une couche d'AlN comportant également au moins un autre métal minoritaire, notamment du zinc, de préférence dans une proportion de 0,1 à 10% atomique par rapport à l'aluminium.

3. Substrat selon la revendication 1 ou la revendication 2, ***caractérisé en ce que*** la couche antireflets comprend une séquence de couche à base d'AlN/couche à base d'oxyde de zinc, la première présentant un niveau de contrainte en traction, la seconde un niveau de contrainte en compression.

4. Substrat selon l'une des revendications précédentes, ***caractérisé en ce que*** la couche d'oxyde, notamment à base de ZnO, de la couche antireflets « inférieure » est contiguë à la couche fonctionnelle.

5. Substrat selon l'une des revendications 1 à 3, ***caractérisé en ce qu***'entre la couche antireflets « inférieure » et la couche fonctionnelle est disposée une fine couche métallique, notamment de type titane ou alliage au Ni du type alliage NiCr ou niobium.

6. Substrat selon l'une des revendications précédentes, ***caractérisé en ce que*** l'empilement comprend au moins deux couches fonctionnelles du type couche Ag, avec une couche antireflets « intermédiaire » entre les deux couches fonctionnelles ou entre deux couches fonctionnelles successives.

7. Substrat selon la revendication 6, ***caractérisé en ce que*** la couche antireflets « intermédiaire » ou au moins l'une d'entre elles comporte une monocouche à base d'AlN modifié de façon à ce que son niveau de contrainte soit équilibré ou est une superposition de couches comprenant au moins une couche à base d'AlN surmontée d'une couche d'oxyde métallique de type ZnO dont les niveaux de contrainte s'annulent au moins pour partie.

8. Substrat selon l'une des revendications précédentes, ***caractérisé en ce que*** la couche fonctionnelle ou au moins l'une d'entre elles est surmontée d'une fine couche métallique sacrificielle, notamment du type Nb, Ti, NiCr.

9. Substrat selon l'une des revendications précédentes, ***caractérisé en ce que*** les couches antireflets « intermédiaires » et/ou « supérieures » contiennent des couches à base d'oxyde métallique choisis parmi : SnO₂, Ta₂O₅, Nb₂O₅, ZnO, TiO₂ ou des couches à base de nitrures du type AIN, Si₃N₄.

10. Film polymère de type PET (polytéréphtalate d'éthylène) revêtu conformément à l'une des revendications précédentes, ***caractérisé en ce qu'il*** est essentiellement dépourvu de rayon de courbure involontaire.

11. Utilisation du film selon la revendication 10 pour fabriquer des vitrages feuilletés fonctionnalisés, anti-solaires ou bas-émissifs.

12. Vitrage feuilleté, ***caractérisé en ce qu'il*** incorpore le film polymère selon la revendication 10.

13. Procédé de fabrication du substrat sous forme de film de polymère souple revêtu selon l'une des revendications 1 à 10, ***caractérisé en ce qu***'on utilise la technique de pulvérisation cathodique pour le dépôt des couches de l'empilement, en modulant des conditions de dépôt de la ou des couches de la couche antireflets « inférieure » de façon à minimiser le niveau de contrainte résiduel de ladite couche antireflets « inférieure » de façon à n'induire substantiellement aucune courbure dans le film du fait des contraintes internes.

14. Empilement de couches réfléchissant le rayonnement thermique pour substrats transparents, comprenant au moins une couche fonctionnelle formée d'argent et des couches antireflets qui sont disposées des deux côtés de la couche d'argent et qui sont formées d'un ou plusieurs composés métalliques, la couche antireflets disposée sous la couche d'argent comprenant une couche partielle supérieure formée d'oxyde de zinc immédiatement contiguë à la couche d'argent et une couche partielle supplémentaire disposée par dessous, ***caractérisé en ce que*** la couche partielle supplémentaire qui est disposée sous la couche d'oxyde de zinc et qui appartient à la couche antireflets « inférieure » est une couche à base de nitrure d'aluminium (AlN) se trouvant sous des contraintes de traction internes qui compensent/annulent au moins pour partie les contraintes de la couche d'oxyde de zinc.

15. Empilement de couches suivant la revendication 14, ***caractérisé en ce que*** l'ampleur des contraintes de traction internes de la couche de nitrure d'aluminium correspond par ajustement des paramètres de revêtement à peu près à l'ampleur des contraintes de compression internes dans la couche d'oxyde de zinc de façon que les contraintes de traction et de compression des deux couches partielles contiguës s'égalisent au moins pour la majeure partie.

16. Empilement de couches suivant la revendication 14 ou 15, ***caractérisé en ce que*** la couche d'oxyde de zinc a une épaisseur de moins de 15 nm et, de préférence, de moins de 12 nm.

17. Empilement de couches suivant l'une quelconque des revendications 14 à 16, ***caraetérisé en ce qu'il*** comprend deux couches fonctionnelles formées d'argent qui sont séparées l'une de l'autre par une couche antireflets supplémentaire, cette couche antireflets supplémentaire comprenant aussi deux couches partielles à savoir une couche immédiatement contiguë à la couche d'argent supérieure et formée d'oxyde de zinc se trouvant sous des contraintes de compression internes et une couche partielle contiguë. à la couche d'argent inférieure et formée de nitrure d'aluminium se trouvant sous des contraintes de traction internes.

18. Empilement de couches suivant l'une quelconque des revendications 14 à 17, ***caractérisé par*** la structure suivante :
(substrat)/AlN/ZnO/Ag/Ti/TiO₂

19. Empilement de couches suivant l'une quelconque des revendications 14 à 16, ***caractérisé par*** la structure suivante :
(substrat)/AlN/ZnO/Ag/AlN

20. Empilement de couches suivant la revendication 17, ***caractérisé par*** la structure suivante :
(Substrat)/AlN/ZnO/Ag/AlN/ZnO/Ag/AlN

21. Utilisation d'un empilement de couches suivant l'une quelconque des revendications 14 à 20 pour revêtir des films de polymère mince, en particulier de PET, de façon que les paramètres de revêtement des couches à base d'AlN formées par pulvérisation réactive à partir d'une cathode d'aluminium métallique soient choisis tels que le film revêtu ne présente, après la formation de l'empilement, pas de courbure sensible induite par des contraintes internes.

## Patentansprüche

1. Transparentes Substrat, insbesondere in Gestalt einer flexiblen Polymerfolie, versehen mit einem Dünnschichtsystem, bestehend aus wenigstens einer metallischen Funktionsschicht der Art Ag mit Infrarot-Reflexionseigenschaften, angeordnet zwischen zwei Entspiegelungsschichten auf der Basis von dielektrischem Material, **dadurch gekennzeichnet, dass** die untere Entspiegelungsschicht, angeordnet zwischen der Funktionsschicht und dem Substrat, eine Einfachschicht auf modifizierter AIN-Basis (Aluminium-Nitrid) ist, deren Spannungsniveau ausgeglichen ist, oder eine Überlagerung von Schichten, bestehend aus wenigstens einer von einer Metalloxid-Schicht überdeckten AIN-Schicht, deren Spannungsniveaus sich wenigstens zum Teil kompensieren / aufheben.

2. Substrat nach Anspruch 1, **dadurch gekennzeichnet, dass** die untere Entspiegelungsschicht eine AIN-Schicht beinhaltet, die ebenfalls wenigstens eine geringe Menge eines anderen Metalls enthält, insbesondere Zink, vorzugsweise im Verhältnis von 0,1 bis 10% in Bezug auf Aluminium.

3. Substrat nach Anspruch 1 oder Anspruch 2, **dadurch gekennzeichnet, dass** die Entspiegelungsschicht eine Sequenz einer AIN-Schicht / Zinkoxid-Schicht umfasst, wovon die erste eine Zugspannung und die zweite eine Druckspannung aufweist.

4. Substrat nach einem der vorstehenden Ansprüche, **dadurch gekennzeichnet, dass** die Oxid-Schicht, insbesondere auf ZnO-Basis, der unteren Entspiegelungsschicht an die Funktionsschicht angrenzt.

5. Substrat nach einem der Ansprüche 1 bis 3, **dadurch gekennzeichnet, dass** zwischen der unteren Entspiegelungsschicht und der Funktionsschicht eine dünne Metall-Schicht, insbesondere aus Titan oder aus einer Ni-Legierung des Typs NiCr oder aus Niobium angeordnet ist.

6. Substrat nach einem der vorigen Ansprüche, **dadurch gekennzeichnet, dass** das Schichtsystem mindestens zwei Funktionsschichten vom Typ Ag-Schicht mit einer Entspiegelungsschicht zwischen den beiden Funktionsschichten oder zwischen zwei aufeinanderfolgenden Funktionsschichten umfasst.

7. Substrat nach Anspruch 6, **dadurch gekennzeichnet, dass** die Entspiegelungs-Zwischenschicht oder mindestens eine von ihnen eine Einfachschicht auf AIN-Basis, derart modifiziert, dass ihr Spannungsniveau ausgeglichen ist, oder eine Überlagerung von Schichten umfasst, bestehend aus wenigstens einer von einer Metalloxid-Schicht des Typs ZnO überdeckten AlN-Schicht, deren Spannungsniveaus sich wenigstens zum Teil aufheben.

8. Substrat nach einem der vorstehenden Ansprüche, **dadurch gekennzeichnet, dass** die Funktionsschicht oder wenigstens eine von diesen mit einer dünnen metallischen Schicht, insbesondere vom Typ Nb, Ti, NiCr, überzogen ist.

9. Substrat nach einem der vorstehenden Ansprüche, **dadurch gekennzeichnet, dass** die mittleren und/oder oberen Entspiegelungsschichten Schichten auf Metalloxid-Basis enthalten, ausgewählt aus:SnO₂, Ta₂O₅, Nb₂O₅, ZnO, TiO₂ oder Schichten auf Nitrid-Basis vom Typ AIN, Si₃N₄.

10. Polymerfolie des Typs PET (Polyethylenterephthalat), beschichtet gemäß einem der vorstehenden Ansprüche, **dadurch gekennzeichnet, dass** sie im wesentlichen frei von einem unbeabsichtigten Krümmungsradius ist.

11. Verwendung der Folie nach Anspruch 10 zur Herstellung von Verbundglasscheiben mit Sonnenschutz- oder Niederemissions-Funktion.

12. Verbundglasscheibe, **dadurch gekennzeichnet, dass** sie die Polymer-Folie nach Anspruch 10 enthält.

13. Verfahren zur Herstellung des Substrats in Gestalt einer flexiblen beschichteten Polymerfolie nach einem der Ansprüche 1 bis 10, **dadurch gekennzeichnet, dass** zum Abscheiden der Schichten des Systems die Technik der Katodenzerstäubung verwendet wird, indem die Bedingungen für die Abscheidung der Schicht / der Schichten der unteren Entspiegelungsschicht derart verändert werden, dass das Niveau der restlichen Spannung der besagten unteren Entspiegelungsschicht so minimiert wird, dass in die Folie keine wesentlichen Krümmungen aufgrund innerer Spannungen induziert werden.

14. Wärmestrahlung reflektierendes Schichtsystem für transparente Substrate, bestehend aus mindestens einer aus Silber bestehenden Funktionsschicht und Entspiegelungsschichten, die auf beiden Seiten der Silberschicht angeordnet sind und die aus einer oder mehreren metallischen Zusammensetzungen bestehen, wobei die unter der Silberschicht angeordnete Entspiegelungsschicht eine obere Teilschicht, direkt an die Silberschicht angrenzende aus Zinkoxid umfasst und eine weitere darunter angeordnete Teilschicht, **dadurch gekennzeichnet, dass** die zusätzliche Teilschicht, die unter der Zinkoxidschicht angeordnet ist und die zur unteren Entspiegelungsschicht gehört, eine Schicht auf Aluminiumnitrid(AlN)-Basis ist, die sich unter inneren Zugspannungen befindet, die zumindest teilweise die Spannungen der Zinkoxidschicht kompensieren / aufheben.

15. Schichtsystem nach Anspruch 14, **dadurch gekennzeichnet, dass** die Höhe der inneren Zugspannungen der Aluminiumnitridschicht durch Einstellen von Beschichtungsparametern etwa der Höhe der inneren Druckspannungen in der Zinkoxidschicht entspricht, so dass sich die Zug- und die Druckspannung der beiden benachbarten Teilschichten wenigstens zum großen Teil ausgleichen.

16. Schichtsystem nach Anspruch 14 oder 15, **dadurch gekennzeichnet, dass** die Zinkoxidschicht eine Dicke von mindestens 15 nm und vorzugsweise von weniger als 12 nm hat.

17. Schichtsystem nach einem der Ansprüche 14 bis 16, **dadurch gekennzeichnet, dass** es zwei Funktionsschichten aus Silber aufweist, die durch eine zusätzliche Entspiegelungsschicht voneinander getrennt sind, wobei diese zusätzliche Entspiegelungsschicht ebenfalls zwei Teilschichten umfasst, nämlich eine der oberen Silberschicht unmittelbar benachbarte Schicht aus unter innerer Druckspannung stehendem Zinkoxid und eine der unteren Silberschicht benachbarte Teilschicht aus unter innerer Zugspannung sehendem Aluminiumnitrit.

18. Schichtsystem nach einem der Ansprüche 14 bis 17, **gekennzeichnet durch** folgenden Aufbau:
(Substrat/)AlN/ZnO/Ag/Ti/TiO₂

19. Schichtsystem nach einem der Ansprüche 14 bis 16, **gekennzeichnet durch** folgenden Aufbau:
(Substrat)/AlN/ZnO/Ag

20. Schichtsystem nach Anspruch 17, **gekennzeichnet durch** folgenden Aufbau:
(Substrat)/AlN/ZnO/Ag/AlN/ZnO/Ag/AlN

21. Verwendung eines Schichtsystems nach einem der Ansprüche 14 bis 20 zum Beschichten von dünnen Polymerfolien, insbesondere aus PET, mit der Maßgabe, dass die Beschichtungsparameter der aus einer metallischen Aluminiumkatode reaktiv gesputterten AIN-Schichten so gewählt sind, dass die beschichtete Folie nach ihrer Beschichtung keine durch innere Spannungen bedingte wesentliche Krümmung aufweist.

## Claims

1. Transparent substrate, in particular in the form of a film of flexible polymer or polymers, provided with a stack of thin layers comprising at least one metallic functional layer with properties of reflection in the infrared of the Ag type disposed between two layers based on "non-reflecting" dielectric material, **characterised in that** the "bottom" non-reflecting layer disposed between the functional layer and the substrate is a single layer based on modified AlN, aluminium nitride, whose stress level is balanced, or is a superimposition of layers comprising at least one layer of AlN surmounted by a layer of metallic oxide whose stress levels at least partly compensate for each other or cancel each other out.

2. Substrate according to Claim 1, **characterised in that** the "bottom" non-reflecting layer comprises a layer of AlN also comprising at least one other minority metal, in particular zinc, preferably in a proportion from 0.1 to 10% atomic with respect to the aluminium.

3. Substrate according to Claim 1 or Claim 2, **characterised in that** the non-reflecting layer comprises a sequence consisting of a layer based on AlN and a layer based on zinc oxide, the first having a tensile stress level, the second a compressive stress level.

4. Substrate according to one of the preceding claims, **characterised in that** the oxide layer, in particular based on ZnO, of the "bottom" non-reflecting layer is contiguous with the functional layer.

5. Substrate according to one of Claims 1 to 3, **characterised in that**, between the "bottom" non-reflecting layer and the functional layer, there is disposed a fine metallic layer, in particular of the titanium or Ni alloy type of the niobium or NiCr alloy type.

6. Substrate according to one of the preceding claims, **characterised in that** the stack comprises at least two functional layers of the Ag layer type, with an "intermediate" non-reflecting layer between the two functional layers or between two successive functional layers.

7. Substrate according to Claim 6, **characterised in that** the "intermediate" non-reflecting layer or at least one of them comprises a single layer based on AlN modified so that its stress level is balanced or is a superimposition of layers comprising at least one layer based on AlN surmounted by a metallic oxide layer of the ZnO type whose stress levels at least partly cancel each other out.

8. Substrate according to one of the preceding claims, **characterised in that** the functional layer or at least one of them is surmounted by a fine sacrificial metallic layer, in particular of the Nb, Ti or NiCr type.

9. Substrate according to one of the preceding claims, **characterised in that** the "intermediate" and/or "top" non-reflecting layers contain layers based on metallic oxide chosen from amongst: SnO₂, Ta₂O₅, Nb₂O₅, ZnO, TiO₂ or layers based on nitrides of the AlN or Si₃N₄ type.

10. Polymer film of the PET (polyethylene terephthalate) type coated in accordance with one of the preceding claims, **characterised in that** it is essentially devoid of any unintentional radius of curvature.

11. Use of the film according to Claim 10 for fabricating functionalised anti-solar or low-emissive laminated glazing panes.

12. Laminated glazing pane, **characterised in that** it incorporates the polymer film according to Claim 10.

13. Method of fabricating the substrate in the form of a flexible polymer film coated according to one of Claims 1 to 10, **characterised in that** use is made of the technique of cathodic sputtering for the deposition of the layers in the stack, modulating the deposition conditions of the layer or layers of the "bottom" non-reflecting layer so as to minimise the residual stress level of the said "bottom" non-reflecting layer, so as to substantially induce no curvature in the film because of the internal stresses.

14. Stack of layers reflecting thermal radiation for transparent substrates, comprising at least one functional layer formed from silver and non-reflecting layers which are disposed on both sides of the layer of silver and which are formed from one or more metallic compounds, the non-reflecting layer disposed under the silver layer comprising a top partial layer formed from zinc oxide immediately contiguous with the silver layer and an additional partial layer disposed underneath, **characterised in that** the additional partial layer which is disposed under the layer of zinc oxide and which belongs to the "bottom" non-reflecting layer is a layer based on aluminium nitride (AlN) situated below the internal tensile stresses which at least partly compensate for or cancel out the stresses of the zinc oxide layer.

15. Stack of layers according to Claim 14, **characterised in that** the magnitude of the internal tensile stresses of the aluminium nitride layer correspond by adjustment of the coating parameters approximately to the magnitude of the internal compressive stresses in the zinc oxide layer so that the tensile and compressive stresses of the two contiguous partial layers equalise each other at least for the major part.

16. Stack of layers according to Claim 14 or 15, **characterised in that** the layer of zinc oxide has a thickness of less than 15 nm and preferably less than 12 nm.

17. Stack of layers according to any one of Claims 14 to 16, **characterised in that** it comprises two functional layers formed from silver which are separated from each other by an additional non-reflecting layer, this additional non-reflecting layer also comprising two partial layers, namely a layer immediately contiguous with the top layer of silver and formed from zinc oxide situated below the internal compressive stresses and a partial layer contiguous with the bottom silver layer and formed from aluminium nitride situated below the internal tensile stresses.

18. Stack of layers according to any one of Claims 14 to 17, **characterised by** the following structure:
(substrate)/AlN/ZnO/Ag/Ti/TiO₂

19. Stack of layers according to any one of Claims 14 to 16, **characterised by** the following structure:
(substrate)/AlN/ZnO/Ag/AlN

20. Stack of layers according to Claim 17, **characterised by** the following structure:
(substrate)/AlN/ZnO/Ag/AlN/ZnO/Ag/AlN

21. Use of a stack of layers according to any one of Claims 14 to 20 for coating thin polymer films, in particular PET, so that the coating parameters of the layers based on AlN formed by reactive sputtering using a metallic aluminium cathode are chosen such that the coated film does not, after the formation of the stack, have any substantial curvature caused by internal stresses.
